# EUROPEAN PATENT APPLICATION

(11) **EP 3 373 115 A1**
(43) Date of publication of application: **12.09.2018**
(21) Application number: 18154399.2
(22) Date of filing: 31.01.2018
(51) Int. Cl.: G06F 3/01, A63F 13/285, D03D 1/00, H01L 41/08, H01L 41/113

(54) **BIFUNCTIONAL FIBER FOR COMBINED SENSING AND HAPTIC FEEDBACK**

(30) Priority: 09.03.2017 US 201715454399
(71) Applicant: Immersion Corporation, San Jose, CA 95134 (US)
(72) Inventor: CRUZ-HERNANDEZ, Juan Manuel, Montreal, Québec H3Z 1T1 (CA); KHOSHKAVA, Vahid, Montreal, Québec H2X 3R4 (CA)
(74) Representative: Hofstetter, Schurack & Partner

(57) **Abstract**

This disclosure relates to a bifunctional fiber that can be used for both haptic feedback and sensing user interaction. Such bifunctional fibers are useful in structural materials, including as elements of wearables or accessories.

## Description

### Technical Field

This disclosure relates to a bifunctional fiber that can be used for both haptic feedback and sensing user interaction. Such bifunctional fibers are useful in structural materials, including as elements of wearables or accessories.

### Background

Haptic feedback for use in wearables or accessories has traditionally been based on the use of eccentric rotating mass (ERM) motors and linear resonant actuators (LRA). However, these types of actuators are typically bulky and often require large amounts of power, making them difficult to integrate into clothing or other wearables or accessories (i.e., jewelry, etc.). Shape memory alloys have also been used in wearables, but again, power consumption often limits their applicability and ease of integration.

What is needed is a simple mechanism for providing haptic feedback to a user that can readily be implemented in wearable and accessory goods, while also allowing for sensing a user's interaction.

### Summary

This disclosure relates to bifunctional fibers and smart materials for providing haptic feedback to a user and for sensing a user's interaction. The smart materials and bifunctional fibers may be used in various applications, such as wearables and accessory goods.

In exemplary embodiments, disclosed herein is a bifunctional fiber for providing haptic feedback to a user and for sensing a user interaction. In embodiments, the bifunctional fiber includes a first conductive element, a polymeric layer concentrically disposed about the first conductive element, a second conductive element concentrically disposed about the polymeric layer, a first insulating layer concentrically disposed about the second conductive element, a third conductive element concentrically disposed about the first insulating layer, and a second insulating layer concentrically disposed about the third conductive element. Suitably, the bifunctional fiber has a substantially circular cross-section for substantially an entire length thereof.

Also disclosed herein is a bifunctional fiber for providing haptic feedback to a user or for sensing a user interaction, including a first conductive element, a polymeric layer concentrically disposed about the first conductive element, a second conductive element concentrically disposed about the polymeric layer, a power source electrically coupled to the first and/or second conductive element, and an insulating layer concentrically disposed about the second conductive element. Suitably, the bifunctional fiber has a substantially circular cross-section for substantially an entire length thereof.

Also disclosed are smart materials for providing haptic feedback to a user and for sensing a user interaction comprising a structural material, and a bifunctional fiber associated with the structural material. In additional embodiments, disclosed are smart materials for providing haptic feedback to a user and for sensing a user interaction, including a structural material, a bifunctional fiber configured as an actuator associated with the structural material, and a bifunctional fiber configured as a sensor associated with the structural material.

### Brief Description of the Drawings

The foregoing and other features and aspects of the present technology can be better understood from the following description of embodiments and as illustrated in the accompanying drawings. The accompanying drawings, which are incorporated herein and form a part of the specification, further serve to illustrate the principles of the present technology. The components in the drawings are not necessarily to scale.
FIG. 1A shows a smart material for providing haptic feedback to a user and for sensing a user interaction in accordance with an embodiment hereof.
FIG. 1B shows a sectional view of the smart material of FIG. 1A, taken through line B-B, in accordance with an embodiment hereof.
FIG. 2A shows a bifunctional fiber in accordance with an embodiment hereof.
FIGS. 2B-2C show sectional views of alternatives of the bifunctional fiber of FIG. 2A, taken through line B-B, in accordance with an embodiment hereof.
FIG. 3A shows an additional bifunctional fiber in accordance with an embodiment hereof.
FIGS. 3B-3C show sectional views of alternatives of the bifunctional fiber of FIG. 3A, taken through line B-B, in accordance with an embodiment hereof.
FIG. 4A shows a smart material containing a bifunctional fiber for providing haptic feedback to a user and for sensing a user interaction, in accordance with an embodiment hereof.
FIG. 4B shows a sectional view of the bifunctional fiber used in FIG. 4A.
FIG. 5A shows a further smart material containing a bifunctional fiber for providing haptic feedback to a user and for sensing a user interaction, in accordance with an embodiment hereof.
FIGS. 5B-5D show sectional views of the bifunctional fibers of the smart material shown in FIG. 5A.
FIGS. 6A-6C show alternative arrangements of bifunctional fibers in smart materials in accordance with embodiments hereof.

### Detailed Description

Various embodiments will be described in detail, some with reference to the drawings. Reference to various embodiments does not limit the scope of the claims attached hereto. Additionally, any embodiments set forth in this specification are not intended to be limiting and merely set forth some of the many possible embodiments for the appended claims.

Whenever appropriate, terms used in the singular also will include the plural and vice versa. The use of "a" herein means "one or more" unless stated otherwise or where the use of "one or more" is clearly inappropriate. The use of "or" means "and/or" unless stated otherwise. The use of "comprise," "comprises," "comprising," "include," "includes," "including," "has," and "having" are interchangeable and not intended to be limiting. The term "such as" also is not intended to be limiting. For example, the term "including" shall mean "including, but not limited to."

In embodiments, provided herein are smart materials for providing haptic feedback to a user and for sensing a user interaction. In embodiments, smart materials include a structural material, a first conductive layer disposed on the structural material, a polymeric layer disposed on the first conductive layer, a second conductive layer disposed on the polymeric layer and an insulator layer disposed on the second conductive layer.

As used herein "smart material(s)" refers to a material that is capable of being controlled such that the response and properties of the material change under the influence of an external stimulus.

As used herein "haptic feedback" or "haptic feedback signal" refer to information such as vibration, texture, and/or heat, etc., that are transferred, via the sense of touch, from a smart material as described herein, to a user.

As used herein, "sensing" or "sensation" refers to the ability of a smart material, bifunctional fiber, or other device or material described herein to interact with, and receive feedback from, a user. In embodiments, the user feedback can be in the form of a touch, pressure, swiping, rubbing, etc. Via the user feedback, the smart material, bifunctional fiber, or other device or material can change or modify and haptic feedback being provided, or can signal a further device based on the interaction.

As used herein, "structural material" means a material used in constructing a wearable, personal accessory, luggage, etc. Examples of structural materials include: fabrics and textiles, such as cotton, silk, wool, nylon, rayon, synthetics, flannel, linen, polyester, woven or blends of such fabrics, etc.; leather; suede; pliable metallic such as foil; Kevlar, etc. Examples of wearables include: clothing; footwear; prosthetics such as artificial limbs; headwear such as hats and helmets; athletic equipment worn on the body; protective equipment such as ballistic vests, helmets, and other body armor. Personal accessories include: eyeglasses; neckties and scarfs; belts and suspenders; jewelry such as bracelets, necklaces, and watches (including watch bands and straps); and wallets, billfolds, luggage tags, etc. Luggage includes: handbags, purses, travel bags, suitcases, backpacks, and including handles for such articles, etc.

As used herein, an "electroactive material" refers to a material that exhibits a change in shape or size when stimulated by an electric field (either direct or alternating current). Exemplary electroactive materials, as described herein, include electroactive polymers and piezoelectric materials.

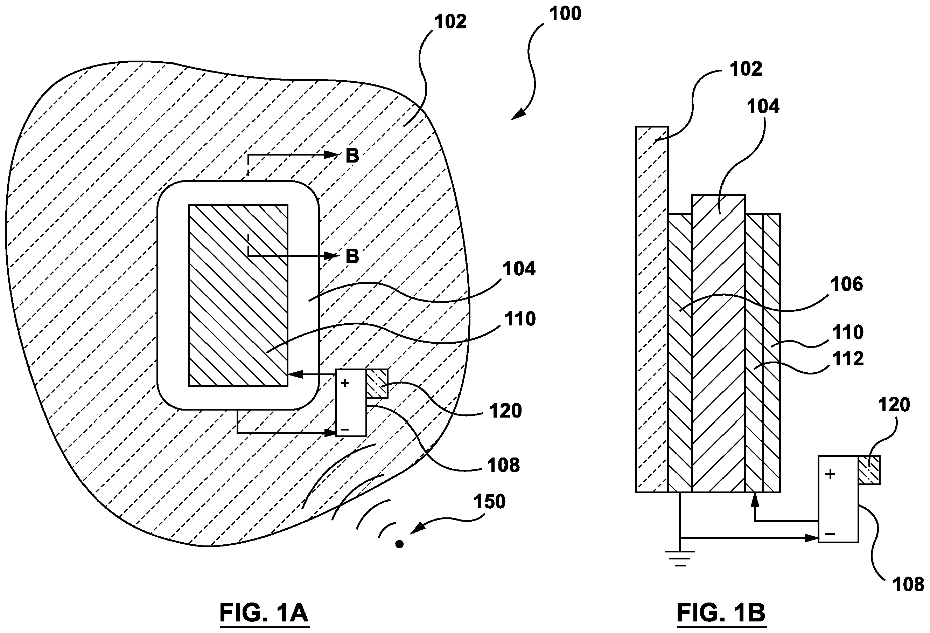

In embodiments as shown in FIGS. 1A-1B, provided herein is a smart material 100 for providing haptic feedback to a user and for sensing a user interaction. In embodiments, smart material 100 includes a structural material 102, a first conductive layer 106 disposed on structural material 102, a polymeric layer 104 disposed on first conductive layer 106, a second conductive layer 112 disposed on polymeric layer 104, and an insulator layer 110 disposed on second conductive layer 112.

As used herein "disposed" refers to the association with or attachment of one layer or material onto another material, so as to form a material which can act as a singular structure. Examples of methods of disposing one or more materials together include use of adhesives, solder, tapes, deposition methods such as thin-film deposition and sputtering, layering, painting, coating, gluing, mechanical attachments such as staples, etc.

As described herein, in embodiments, structural material 102 is a textile, and suitably can be part of a wearable. In embodiments, structural material 102 can be provided with smart material 100 already integrated as part of a textile, for example, as part of a wearable such as a shirt, blouse, gloves, suit, etc. In other embodiments, smart material 100 can be provided separately and then adhered or otherwise attached to structural material 102, e.g., as an adhesive patch or element that can be integrated, woven or sewn onto a textile.

Exemplary materials for use as first 106 and/or second 112 conductive layers include, for example, silver, gold, or other conductive metals or polymer (e.g., thin films of Au, Al, Ag, Cr, poly(3,4-ethylenedioxythiophene) polystyrene sulfonate (PEDOT:PSS), etc.). Suitably, first 106 and/or second 112 conductive layers will have a thickness on the order of about 50 nm to millimeters, e.g., about 50 nm to 5 mm, about 50 nm to 1 mm, about 50 nm to 500 µm, about 100 nm to about 500 µm, about 1 µm to 500 µm, or about 5 µm to about 500 µm, or about 10 µm to 500 µm, or about 1 µm to about 100 µm, though thicker or thinner electroactive materials can also be utilized, depending on the desired use and orientation for the conductive layer(s) with the structural material.

In embodiments, polymeric layer 104 includes an electroactive polymer, which includes polymers such as, but not limited to, poly(vinylidene fluoride), poly(pyrrole), poly(thiophene), poly(aniline) and mixtures, co-polymers, and derivatives thereof. Exemplary classes of electroactive polymers include dielectric and ionic polymers. A dielectric polymer may be made to change shape in response to an electrostatic force being generated between two electrodes that then squeezes the polymer. Dielectric polymers are capable of very high strains and are fundamentally a capacitor that changes its capacitance when a voltage is applied by allowing the polymer to compress in thickness and expand in area due to the electric field. An ionic polymer may undergo a change in shape or size due to displacement of ions inside the polymer. In addition, some ionic polymers require the presence of an aqueous environment to maintain an ionic flow.

Methods of preparing electroactive polymers are known in the art, and can suitably include dissolving a desired polymer in a suitable solvent, and then casting the polymer in the desired shape (i.e., flat ribbon, patch, etc.). Alternatively, the polymer may be drawn, or subjected to fiber spinning techniques, so as to be prepared with the desired filament or fiber dimensions, as described herein. Additional methods include melt mixing, in which the polymer is heated above the softening/melting point, and then the polymer film is processed using film processing (casting or blowing) techniques. The electroactive polymers, if prepared as relatively flat structures, can also be prepared by layering various polymer sections or layers to create the final desired structure.

In additional embodiments, polymeric layer 104 can be a piezoelectric material, including piezoelectric composites and ceramics. Exemplary piezoelectric materials include, but are not limited to, barium titanate, hydroxyapatite, apatite, lithium sulfate monohydrate, sodium potassium niobate, quartz, lead zirconium titanate (PZT), tartaric acid and polyvinylidene difluoride fibers. Other piezoelectric materials known in the art can also be used in the embodiments described herein.

In additional embodiments, polymeric layer 104 can include a shape memory polymer. Shape memory polymers (SMP) allows for programing of the polymer providing it with the ability to change shape from a first to a second shape. The shape-memory effect is not an intrinsic property, meaning that polymers do not display this effect by themselves. Shape memory results from a combination of polymer morphology and specific processing and can be understood as a polymer functionalization. By conventional processing, e.g. extruding or injection molding, the polymer is formed into its initial, permanent shape B. Afterwards, in a process called programming, the polymer sample is deformed and fixed into the temporary shape A. Upon application of an external stimulus (e.g., heat or electric field), the polymer recovers its initial permanent shape B. This cycle of programming and recovery can be repeated several times, with different temporary shapes in subsequent cycles. Shape-memory polymers can be elastic polymer networks that are equipped with suitable stimulisensitive switches. The polymer network consists of molecular switches and net points. The net points determine the permanent shape of the polymer network and can be a chemical (covalent bonds) or physical (intermolecular interactions) nature. Physical cross-linking is obtained in a polymer whose morphology consists of at least two segregated domains, as found for example in block copolymers. Additional information and examples of SMPs can be found in Shape Memory Polymers, MaterialsToday, Vol. 10, pages 20-28 (April 2007), the disclosure of which is incorporated by reference herein in its entirety.

Transformation of SMPs from one or a first configuration to another or a second configuration is suitably controlled by controlling the temperature of the SMP in relation to its glass transition temperature (Tg). Raising the temperature of the SMP by heating it above its Tg, will cause the SMP actuator to transition to its second (memorized or original) configuration, resulting in activation or actuation of the multi-stable material and moving or transforming from a first stable configuration to a second stable configuration, and suitably to a third (and fourth, fifth etc., if desired) stable configuration. Exemplary shape memory polymers include various block copolymers, such as various poly(urethanes), poly(isoprene) and poly(ether esters), which have been programmed to have the required shape memory characteristics.

Polymeric layer 104 will suitably have a thickness on the order of about 5 µm to millimeters, e.g., about 1 µm to 5 mm, about 1 µm to 1 mm, about 1 µm to 500 µm, or about 5 µm to about 500 µm, or about 10 µm to 500 µm, or about 1 µm to about 100 µm, though thicker or thinner polymer layers can also be utilized.

As described herein, power source 108 is suitably electrically coupled, i.e., connected to smart material 100. The amount of power provided by power source 108 is generally on the order of about 0.1 Watts (W) to about 10 W, or more suitably about 0.5 W to about 5 W, or about 1 W to about 5 W, or about 0.5 W, about 1 W, about 2 W, about 3 W, about 4 W or about 5 W. Exemplary power sources 108 include various battery packs as well as solar energy sources. Power source 108 can also include a re-chargeable system, for example, a system capable of recharging through the use of a piezoelectric material, as described herein, providing a current to the system.

As shown in FIGS. 1A-1B in response to an external activating signal 150, power source 108 can provide electrical power to first 106 and/or second 112 conductive layers (or one layer can be wired as ground as required) to cause a change in shape or configuration of polymeric layer 104, resulting in haptic feedback to a user. This haptic feedback can be in the form of a pulse, vibration, pressure, etc. In additional embodiments, smart material 100 also senses a user interaction. For example, a user interaction can result in a compression of polymeric layer 104 and a change in capacitance or resistance of smart material 100. This change in capacitance or resistance can be measured by a measurement apparatus 120 by monitoring the change in electric field between the first and second conductive layers. Measurement apparatus 120 can be either wired or wirelessly connected to smart material 100, allowing for the determination of a user's interaction with smart material 100, e.g., as a pressure sensor.

In further embodiments, provided herein is a bifunctional fiber for providing haptic feedback to a user and/or for sensing a user interaction. As used herein a "bifunctional fiber" refers to a filament or fiber structure having a length that is at least twice as long as its cross-section, with a substantially uniform cross-section for substantially an entire length thereof. "Bifunctionality" refers to the ability of the fiber to function as both an actuator for providing haptic feedback, as well as a sensor for sensing user interaction, such as touch, pressure, sweeping or swiping motion, etc. A bifunctional fiber can include sections which include elements that allow the same fiber to function as both an actuator and a sensor, or can be configured so as to act as an actuator under certain circumstances, and then as a sensor, under a further set of circumstances. Thus, in certain situations, a bifunctional fiber can function as a sensor if wired appropriately, whereas the same type of bifunctional fiber can also act as an actuator, if wired differently, as described herein. Generally, the ability to function as actuator or sensor occurs in the wiring or configuration of the fiber, as described herein. The terms "fiber" and "filament" are used interchangeably herein to refer to such structures.

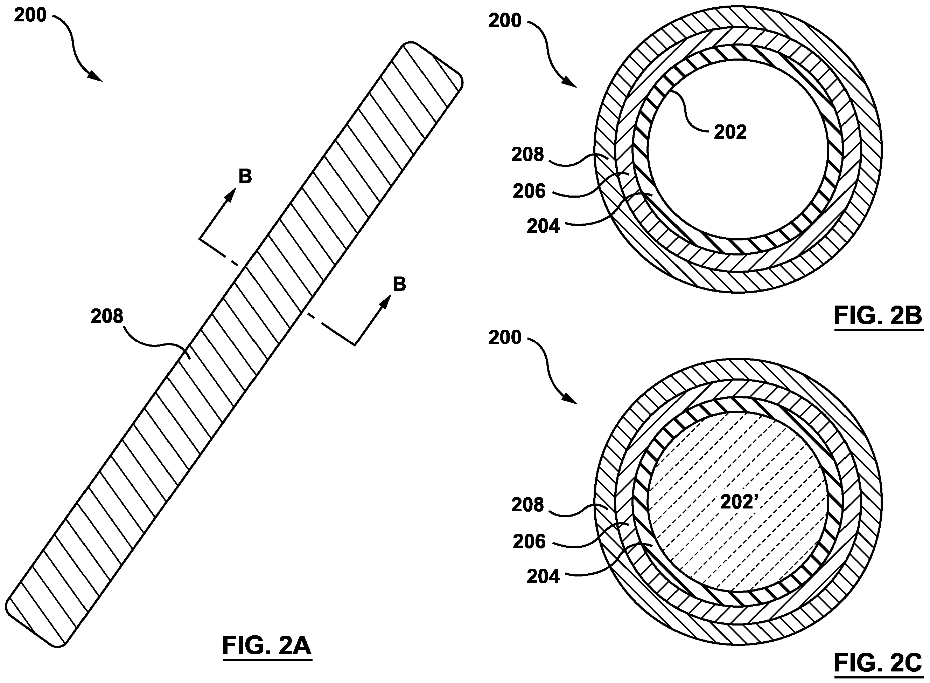

FIG. 2A shows a bifunctional fiber 200 in accordance with embodiments hereof for providing haptic feedback to a user or for sensing a user interaction. That is, bifunctional fiber 200 can act as either an actuator or as a sensor, depending on how the fiber is connected to power and configured. In embodiments, bifunctional fiber 200 includes a section of the fiber for providing haptic feedback or for sensing user interaction. As used herein "section" refers to a portion of a bifunctional fiber, and suitably refers to a set or subset of layers of materials that make up the bifunctional fiber. In embodiments, bifunctional fiber 200 a section for providing haptic feedback or for sensing user interaction which includes a first conductive element 202, a polymeric layer 204 concentrically disposed about first conductive element 202, a second conductive element 206 concentrically disposed about polymeric layer 204, and an insulating layer 208 concentrically disposed about second conductive element 206. As described throughout, the bifunctional fiber has a substantially circular cross-section for substantially an entire length thereof.

FIG. 2B shows a section through line B-B of bifunctional fiber 200, in which a hollow core fiber is utilized or employed. FIG. 2C shows a sectional view through line B-B of bifunctional fiber 200, in which a solid core fiber is utilized or employed. In embodiments, as shown in FIG. 2B, first conductive element 202 forms a hollow core of bifunctional fiber 200, forming a substantially circular cross-section of the bifunctional fiber. In FIG. 2C, first conductive element 202' is a solid core of bifunctional fiber 200, forming a substantially circular cross-section of the bifunctional fiber.

As shown in FIG. 2B, first conductive element 202 essentially forms a coating or inner lining of polymeric layer 204, thereby providing the hollow core structure of bifunctional fiber 200. In FIG. 2C, polymeric layer 204 is concentrically disposed about the solid core of first conductive element 202', forming a coating surrounding the solid core structure of bifunctional fiber 200.

As described herein, bifunctional fiber 200, whether including a solid or hollow core structure, has a substantially uniform cross-section for substantially an entire length of the bifunctional fiber, and in certain embodiments, has a substantially circular cross-section for substantially an entire length of the bifunctional fiber. It is this substantially uniform cross-section (and in embodiments the substantially circular cross-section) that provides bifunctional fiber 200 with one of its characteristics to allow for use or integration in structural materials, including wearables, as described herein. "Substantially uniform cross-section" means that a section taken through the bifunctional fiber has a cross-section that is uniform, i.e., within about 5-10% throughout "substantially an entire length" of the bifunctional fiber. "Substantially circular cross-section" means that a section taken through the bifunctional fiber has a diameter that is uniform, i.e., within about 5-10% throughout "substantially an entire length" of the bifunctional fiber. "Substantially an entire length" means at least 80-90% of the entire length of the bifunctional fiber. In embodiments, the bifunctional fiber has a cross-section, and suitably a diameter, that is uniform within about 1-5% (suitably within about 4%, about 3%, about 2% about 1% or about 0.5%) over at least about 90-95%, and suitably 95% or more (e.g., 96%, 97%, 98%, 99% or 100%) of the entire length of the bifunctional fiber. In further embodiments, other cross-sections (i.e., square, rectangular, triangular, oval, etc.), can also be used that are also substantially uniform, as described herein.

Exemplary conductive elements for use in bifunctional fiber 200 include, but are not limited to, silver, gold, various conductive metals or polymers, including, Al, Cr, poly(3,4-ethylenedioxythiophene), polystyrene sulfonate (PEDOT:PSS), etc.). In embodiments where the first conductive element forms a solid core, as FIG. 2C, first conductive element 202' can be a solid wire or filament of a conductive element, including a gold or silver wire, etc. Polymeric layer 204 can then be disposed, coated or otherwise associated with the solid core to form the concentrically disposed structure. As used herein "concentrically disposed" refers to a layer(s) of material that is applied or coated on a structure, such that the layers have the same circular center when viewed in cross-section.

In embodiments where first conductive element 202 forms a hollow core, as in FIG. 2B, the inner surface of polymeric layer 204 can be coated or covered with a film or coating of a metal or other material, to form first conductive element 202. Similarly, second conductive element 206 can also be coated or disposed on polymeric layer 204, thereby forming the structure shown in FIG. 2B. For example, a hollow polymeric fiber or filament can be prepared, using for example, a fiber spinning method wherein concentric cylinders are used, and a polymer fills in the gaps between the cylinders to form a hollow fiber, such as polymeric layer 204. First conductive element 202 can then be applied to the inner surface of polymeric layer 204 to form the hollow fiber structure. Similarly, second conductive element 206 can be applied to the outer surface of the hollow fiber, polymeric layer 204, to form the structure shown in FIG. 2B. Methods of applying the first and second conductive elements can include sputtering, dip-coating, spraying, electro-plating, painting, etc. In embodiments, surface patterning can be used to selectively etch the surface of polymeric layer 204 to increase the surface area or create a desired structure which can then be coated or covered with a thin film of conductive material to create the first and/or second conductive elements described herein.

The bifunctional fibers described herein can also include conductive elements spaced apart from each other along the length of the fiber, with sections in between that do not contain conductive elements, thereby creating an alternating of electrode/non-electrode sections along the length.

Polymeric layer 204 will suitably have a thickness on the order of about 5 µm to millimeters, e.g., about 1 µm to 5 mm, about 1 µm to 1 mm, about 1 µm to 500 µm, or about 5 µm to about 500 µm, or about 10 µm to 500 µm, or about 1 µm to about 100 µm, though thicker or thinner polymer layers can also be utilized.

First conductive element 202', in the form of a solid core structure, can have a diameter on the order of 5 µm to millimeters, e.g., about 1 µm to 10 mm, about 1 µm to 5 mm, about 1 µm to 1 mm, about 1 µm to 500 µm, or about 5 µm to about 500 µm, or about 10 µm to 500 µm, or about 1 µm to about 100 µm. When first conductive element is in the form of a coating or layer, as in FIG. 2B, the thickness of the conductive element will generally be on the order of microns, suitably about 0.5 µm to about 500 µm, more suitably about 0.5 µm to about 100 µm, or about 0.5 µm to about 50 µm.

Overall, the diameter of the bifunctional fibers described herein is suitably on the order of 10's to 100's of microns, or up to millimeters, for example, on the order of about 1 µm to 10 mm, about 1 µm to 5 mm, about 1 µm to 1 mm, about 1 µm to 500 µm, or about 5 µm to about 500 µm, or about 10 µm to 500 µm, or about 1 µm to about 100 µm. The length of the bifunctional fibers can be on the order of microns to millimeters to centimeters to meters, depending on the ultimate application and use of the fiber actuator.

Polymeric layer 204 suitably includes an electroactive polymer. Electroactive polymers include polymers such as, but not limited to, poly(vinylidene fluoride), poly(pyrrole), poly(thiophene), poly(aniline) and mixtures, co-polymers, and derivatives thereof. Exemplary classes of electroactive polymers include dielectric and ionic polymers. A dielectric polymer (or dielectric elastomer) may be made to change shape in response to an electric field being generated between two electrodes that then squeezes the polymer. Dielectric polymers are capable of very high strains and are fundamentally a capacitor that changes its capacitance when a voltage is applied by allowing the polymer to compress in thickness and expand in area due to the electric field. An ionic polymer may undergo a change in shape or size due to displacement of ions inside the polymer. In addition, some ionic polymers require the presence of an aqueous environment to maintain an ionic flow.

Additional examples of compositions useful as polymer layer 204 include piezoelectric polymers and shape memory polymers. Exemplary piezoelectric materials include, but are not limited to, barium titanate, hydroxyapatite, apatite, lithium sulfate monohydrate, sodium potassium niobate, quartz, lead zirconium titanate (PZT), tartaric acid and polyvinylidene difluoride fibers. Other piezoelectric materials known in the art can also be used in the embodiments described herein.

In additional embodiments, polymeric layer 204 can include a shape memory polymer, as described herein.

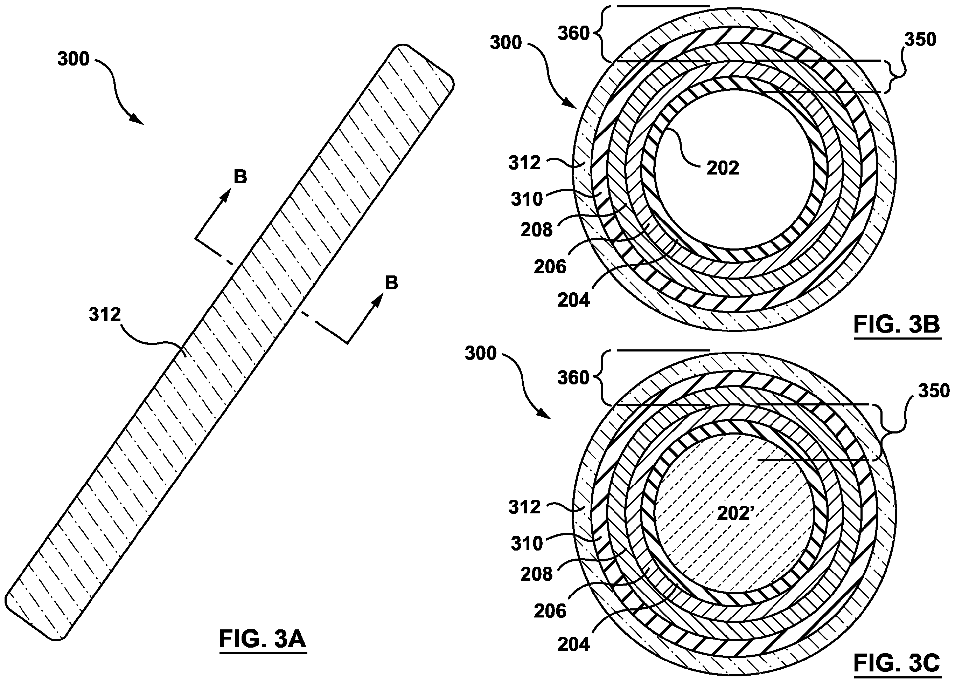

FIG. 3A shows a further bifunctional fiber 300 in accordance with an embodiment hereof. FIG. 3B shows a sectional view of bifunctional fiber 300 taken through line B-B, illustrating a section 350 of the fiber for providing haptic feedback, including first conductive element 202, and a polymeric layer 204 concentrically disposed about first conductive element 202. Bifunctional fiber 300 also includes a section 360 of the fiber for sensing user interaction, which includes a second conductive element 206 concentrically disposed about polymeric layer 204 a first insulating layer 208 concentrically disposed about second conductive element 206, a third conductive element 310 concentrically disposed about first insulating layer 208, and a second insulating layer 312 concentrically disposed about third conductive element 310. As described herein the bifunctional fiber has a substantially circular cross-section for substantially an entire length thereof.

It should be understood that section 350 of the bifunctional fiber for providing haptic feedback can also include additional layers or elements as described herein, and that section 360 of the bifunctional fiber for sensing user interaction can also include additional layers or elements as described herein. There additional layers or elements, for example additional insulating layers or polymeric layers, do not interfere with the ability of section 350 or section 260 to provide haptic feedback and/or sense user interaction, as described herein.

As described herein, the first conductive element can be in the form of a hollow core (202 in FIG. 3B), or can be in the form of solid core (202' in FIG. 3C). Methods of preparing the solid cores or hollow cores, as well as methods of disposing the various layers to construct bifunctional fiber 300 are described herein.

Exemplary conductive elements for use in bifunctional fiber 300 include, but are not limited to, silver, gold, various conductive metals or polymers, including, Al, Cr, poly(3,4-ethylenedioxythiophene), polystyrene sulfonate (PEDOT:PSS), etc.). Such materials include a solid wire or filament of a conductive element, including a gold or silver wire, etc., as well as coatings various metals, such as gold or silver.

As described herein, polymeric layer 204 can include an electroactive polymer, including, but not limited to, layers of poly(vinylidene fluoride), poly(pyrrole), poly(thiophene), poly(aniline) and mixtures, co-polymers, and derivatives thereof. Additional materials for use in polymeric layer 204 include shape memory polymers.

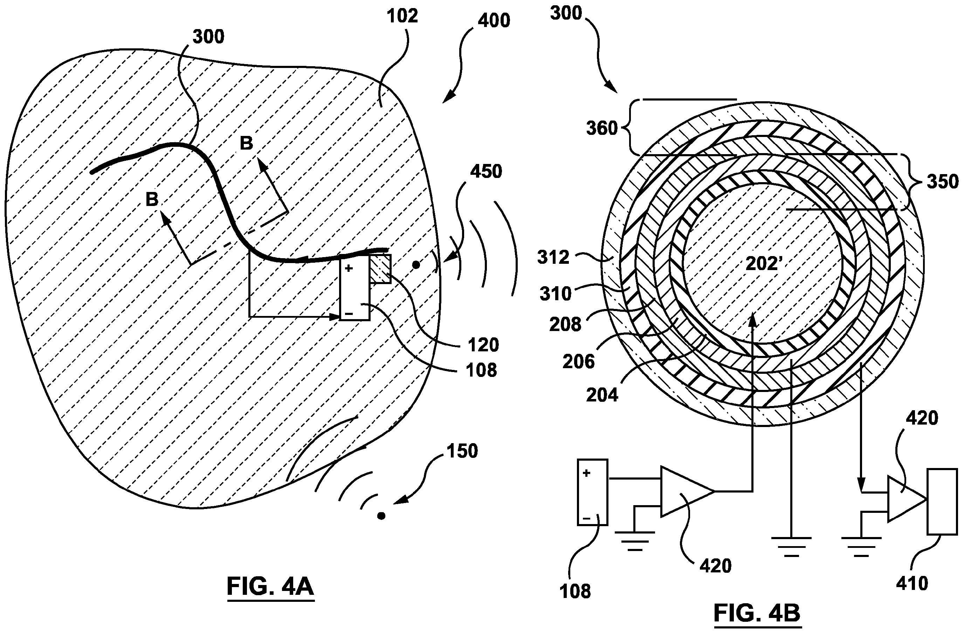

As shown in FIG. 4A, bifunctional fiber 300 can be associated or integrated with structural material 102 to form a smart material 400. As described herein, structural material 102 can be a textile, including part of various wearables as described throughout.

FIG. 4B shows a sectional view taken through line B-B of bifunctional fiber 300. As shown, in embodiments, power source 108 can be electrically coupled to first section 350 of bifunctional fiber 300, i.e., connected such that first conductive element, i.e., core 202', is connected to an electric circuit, which can include power source 108, as well as amplifier 420, which can provide an activation signal to bifunctional fiber 300. Amplifier 420 can also be used to amplify a control signal (including amplifying power therefrom) to provide the necessary power to power the actuator. Second conductive element 206, which is concentrically between first conductive element 202' and third conductive element 310, is suitably connected to ground. Second section 360 of bifunctional fiber 300 can include third conductive element 310 suitably connected to a measurement device 410 for determining capacitance and/or resistance, and can also be connected to an additional amplifier 420, which aids in various signal conversion/amplification as required, when receiving a signal from the bifunctional fiber and transmitting it to the measurement device. Power source 108 and measurement device 410, can share the same ground. In such a configuration, polymeric layer 204 can deform in response to an electric field between the first conductive element 202' and the second conductive element 206, to act as section 350 of the bifunctional fiber that provides the haptic feedback. This can be in the form of a deformation or movement of the polymeric layer, or in the form of electrostatic feedback, in response to an activating signal 150, for example from an external device. Haptic feedback can also be provided with a combination of mechanical (i.e., deformation or movement) as well as electrostatic feedback. At the same time, user interaction which results in compression of polymeric layer 204, and/or of insulator layer 208, can be sensed by section 360 of the bifunctional fiber as a change in the electric field between the first conductive element 202' and the third conductive element 310, and measured by measurement device 410, in the form of a change in resistance or capacitance of the bifunctional fiber. The change can also be measured as a change in pressure. Thus, bifunctional fiber 300 provides both haptic feedback and senses user interaction (e.g., as a pressure sensor), via different sections of the same fiber.

Exemplary devices for use as measurement device 410 for determining capacitance or resistance are well known in the art, and include various ohmmeters, pressure sensors and capacitance meters (and combinations of such sensors). Such devices suitably contain a small power source (i.e., on the order of a few volts). In other embodiments, an additional power source can be used to provide measurement device 410 with the requisite power to function as desired.

In the bifunctional fibers described herein, polymeric layer 204 is suitably a soft polymer, including for example an electroactive polymer, or a shape memory polymer. The malleability or flexibility of the polymer layer allows for it to deform or change shape in response to an electric field (and heating if required) applied between the first and second conductive elements. For example, polymeric layer 204 can contract, causing the fiber actuator to shrink or deform in shape, or can expand, causing the fiber actuator to extend, contract or otherwise deform in shape. In general, the amount of movement or deformation of bifunctional fibers in response to an electric field will be on the order of a few percent (0.5-5%) of the total diameter and/or length of the bifunctional fibers.

Electrostatic feedback from the bifunctional fibers described herein can be in the form of a short vibration or pulse, or an extended vibration to the user. The frequency of the electrostatic feedback or interaction can be on the order of about 1 Hz to about 1000 Hz, more suitably about 1 Hz to about 500 Hz, about 1 Hz to about 200 Hz, about 10 Hz to about 200 Hz, about 10 Hz to about 100 Hz, or about 10 Hz, about 20 Hz, about 30 Hz, about 40 Hz, about 50 Hz, about 60 Hz, about 70 Hz, about 80 Hz, about 90 Hz or about 100 Hz. Haptic feedback can also be provided by the electrostatic interaction if a user simply approaches, or is near, the smart material or bifunctional fiber, signaling a close proximity to the smart material or fiber, which may result in the electrostatic interaction and the haptic feedback therefrom.

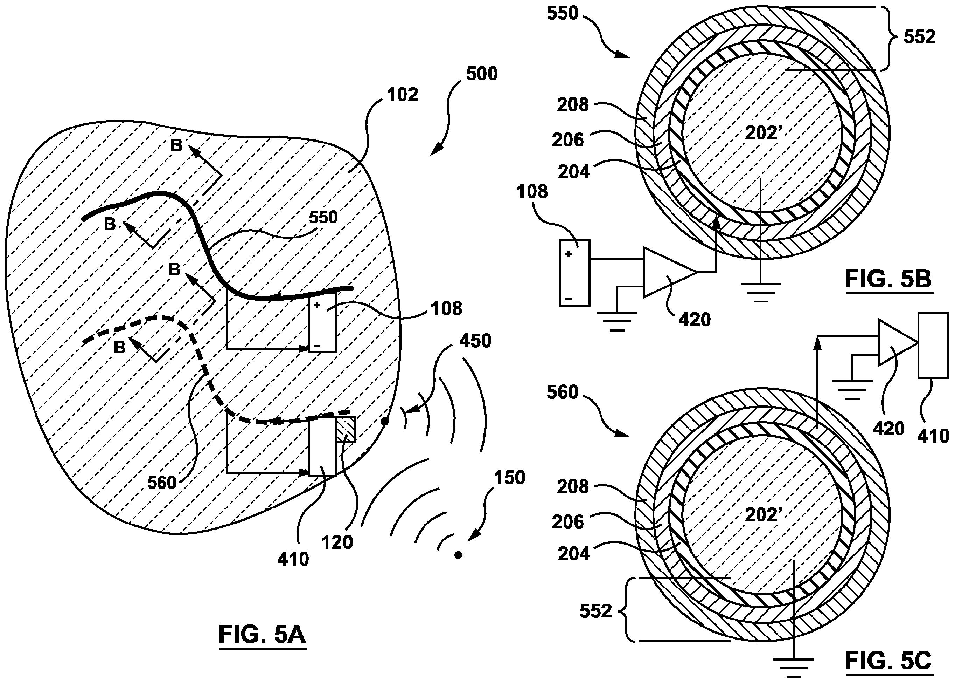

In additional embodiments, bifunctional fiber 200 can be integrated into or associated with structural material 102, for example as shown in FIG. 5A, so as to form a smart material 500. In embodiments, structural material 102 can be a textile, and can be incorporated into wearable articles, such as, wearables textiles, including shirts, blouses, hats, jackets, coats and pants/shorts, resulting in a wearable smart material. The structural materials can also be integrated into accessories, including various leather goods, including wallets and purses, handbags (including handles of such), backpacks, and jewelry, etc.

As used herein "integrated" with respect to the bifunctional fibers refers to the bifunctional fibers being woven, sewn, stitched, or otherwise made a part of structural material 102, such that it is not readily removed or disassociated from structural material 102. That is, the bifunctional fibers described herein can act as a fiber or thread during preparation of structural material 102 or for integration into an already formed structural material, e.g., as a wearable.

As shown in FIG. 5A, in embodiments, and also shown in the sectional view in FIG. 5B, taken through line B-B, bifunctional fiber 550 can be configured to function as an actuator. In such embodiments, the ability of bifunctional fiber 550 to function as either an actuator or a sensor, depending on the connection parameters, is utilized. In embodiments, bifunctional fiber 550, which can include section 552 of the fiber for providing haptic feedback or for sensing using interaction, which includes first conductive element 202' as a solid core as shown in FIG. 5B, can be wired with first conductive element 202 ' connected to ground, and second conductive element 206, connected to power supply 108 (and suitably amplifier 420 and an activating circuit), so as to function as an actuator. In embodiments, polymeric layer 204 can thus be configured to deform in response to an electric field between first conductive element 202' and the second conductive element 206, to provide haptic feedback to a user. In further embodiments, first conductive element 202' and second conductive element 206 can be configured to provide an electrostatic feedback to the user. In such embodiments, insulating layer 208 can come in contact with the user, or the user can come in close contact with bifunctional fiber 550, in order to initiate the electrostatic feedback.

In further embodiments, an additional bifunctional fiber 560 can also be associated with structural material 102 as in smart material 500, but can be configured as a sensor, as shown in FIG. 5C. Structurally, bifunctional fiber 560 can be the same as bifunctional fiber 550, including section 552 of the bifunctional fiber for providing haptic feedback or for sensing user interaction, but simply wired to measurement device 410 (and amplifier 420 as desired), and ground, in such a way as to act as a sensor, rather than as an actuator, providing an output that is measured by measurement device 410. A small power source can also be provided, or can be included within measurement device 410, so as to provide small voltage (a few volts) to allow for the measurement in the change in capacitance or resistance, upon deformation/compression of polymeric layer 204. For example, measurement device 410 can sense a user interaction which results in compression of polymeric layer 204, thereby causing a change in capacitance or resistance of the bifunctional fiber, or can be measured as a change in pressure. This change in capacitance, pressure or resistance resulting from the compression of polymeric layer 204 can be measured by measurement device 410 as a change in electric field.

As shown in FIG. 5A, smart material 500 suitably includes bifunctional fibers that act as both actuators 550 and sensors 560, integrated or associated with the same structural material 102. Structural material 102 of smart material can be part of a textile, including a wearable, as described herein.

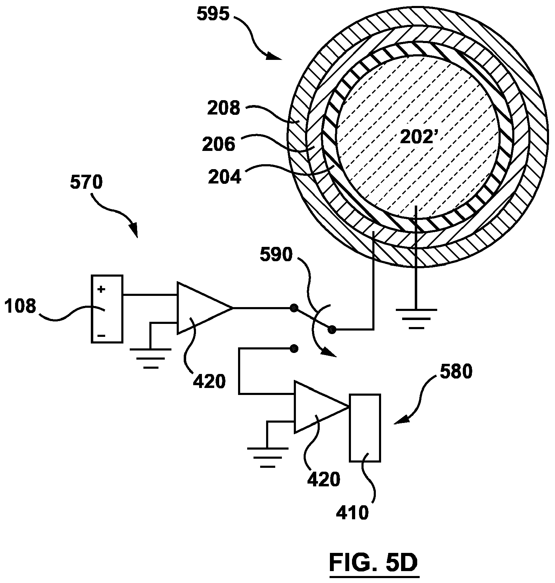

Switching 590 between an actuation or haptic feedback mode and a sensing or user interaction mode in combination with the bifunctional fibers 595 can be accomplished, for example as shown in FIG. 5D. As indicated, a switch can be controlled and actively manipulated from a first position 550 in which bifunctional fiber 595 acts as an actuator (signal is provided by e.g., power source 108, amplifier 420, and suitably a separate actuating circuit) to a second position 580, in which bifunctional fiber 595 provides a signal to measurement device 410 (and suitably amplifier 420), which measures a change in a property of the bifunctional fiber, including a change in capacitance, resistance or pressure, to provide a sensor function to the fiber. Switching 580 can be carried out as many times as desired, and is suitably controlled by an external mechanism or computer, including a processor, but can be manually controlled by a user if desired.

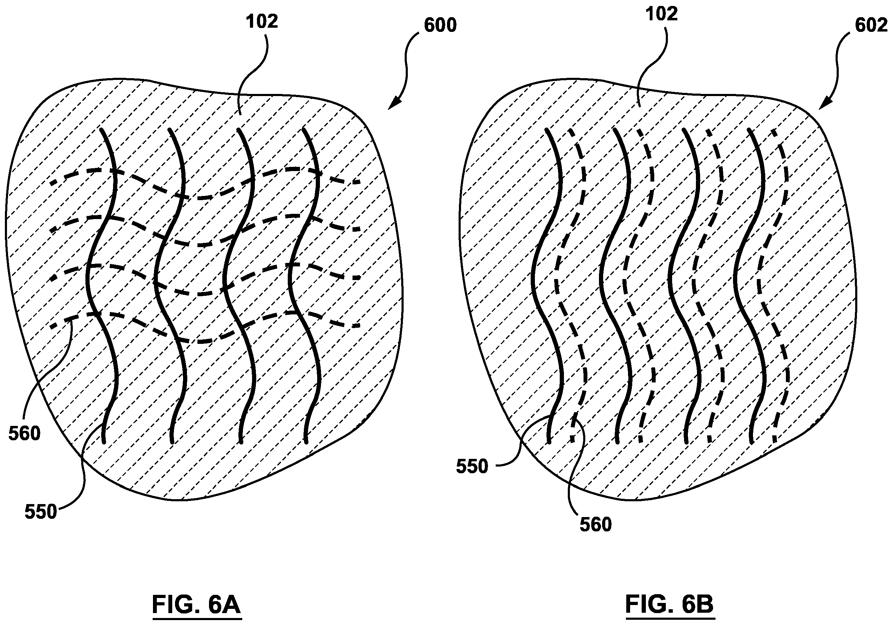

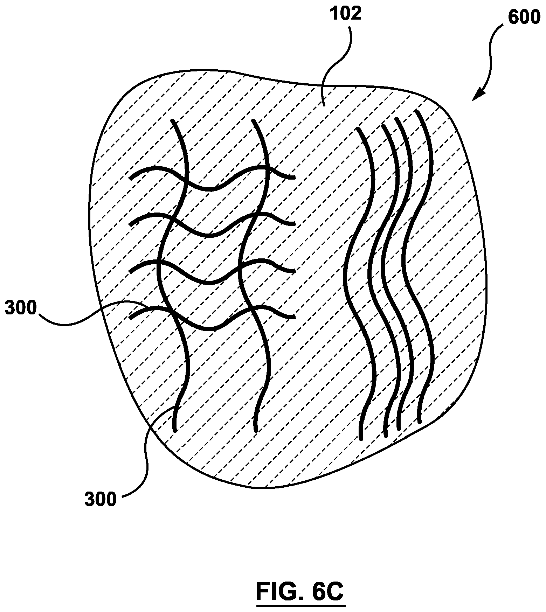

FIGS. 6A-6B show additional configurations of bifunctional fibers in smart materials. For example, in FIG. 6A, smart material 600 can include structural material 102 with integrated or associated bifunctional fibers that can act as actuators (550) and bifunctional fibers that can act as sensors (560), oriented or positioned substantially perpendicular to one another (i.e., within 5-10° of perpendicular, or 90°, to one another). FIG. 6B shows a configuration in which smart material 602 includes structural material 102 and integrated or associated bifunctional fibers that can act as actuators (550) and bifunctional fibers that can act as sensors (560), oriented or positioned substantially parallel to one another (i.e., within 5-10° of parallel). Additional orientations and configurations are also possible to construct the various smart materials as described herein. FIG. 6C shows a configuration for smart material 600 in which bifunctional fibers 300 can be integrated or associated with structural material 102, in either a perpendicular or parallel configuration. Power source 108, measurement device 410, and other components are removed from FIGS. 6A-6B for ease of viewing.

As described herein, the various smart materials can further comprise power source 108 electrically coupled, i.e., connected to the components of the bifunctional fiber. In embodiments, power source 108 can be permanently connected the bifunctional fiber, or in other embodiments, can be separate from the bifunctional fiber, and later connected. The bifunctional fibers can include electrode(s) to establish a connection between the conductive layers and power source 108. Power source 108 can come as an integrated component of the various smart materials described herein, or can be provided separately, or later provided, to supply power. Power source 108 can be electrically coupled to the various components described herein via wired or wireless connections.

In additional embodiments, provided herein are methods for providing haptic feedback to a user via the bifunctional fibers and/or smart materials described herein, as well as sensing user interaction with the bifunctional fibers and/or smart materials.

In embodiments, an activating signal 150 can provide an activation to power source 108, which can generate movement of polymer layer 204, for example a shape change or size change, and thus the movement and actuation of structural material 102 to provide haptic feedback to a user. For example, in embodiments where the structural material is part of a wearable, the actuation causes the structural material to move, providing a haptic feedback to a user in the form of movement in an article of clothing (e.g., shirt, tie, blouse, pants), or as part of an accessory, including a watch, bracelet, etc. In addition, user interaction can be sensed by measurement apparatus 120 and a sensing signal 450 can be sent to an external device to record the interaction with the smart material or bifunctional fiber.

Exemplary activating signals can be from a cellular phone, tablet, computer, car interface, smart device, game console, etc., and can indicate for example the receipt of a text message or e-mail, phone call, appointment, etc. Similarly, sensing signals 450 can be sent to a cellular phone, tablet, computer, car interface, smart device, game console, etc., and can indicate for example the user interacting with the bifunctional fiber or smart material, confirming receipt of the haptic feedback, or other interaction.

In further embodiments, a controller is also suitably included to provide an interface between the device and smart materials or bifunctional fibers, as described herein. Components of a controller are well known in the art, and suitably include a bus, a processor, an input/output (I/O) controller and a memory, for example. A bus couples the various components of controller, including the I/O controller and memory, to the processor. The bus typically comprises a control bus, address bus, and data bus. However, the bus can be any bus or combination of busses suitable to transfer data between components in the controller.

A processor can comprise any circuit configured to process information and can include any suitable analog or digital circuit. The processor can also include a programmable circuit that executes instructions. Examples of programmable circuits include microprocessors, microcontrollers, application specific integrated circuits (ASICs), programmable gate arrays (PGAs), field programmable gate arrays (FPGAs), or any other processor or hardware suitable for executing instructions. In the various embodiments, the processor can comprise a single unit, or a combination of two or more units, with the units physically located in a single controller or in separate devices.

An I/O controller comprises circuitry that monitors the operation of the controller and peripheral or external devices. The I/O controller also manages data flow between the controller and peripherals or external devices. Examples of peripheral or external devices with which the I/O controller can interface include switches, sensors, external storage devices, monitors, input devices such as keyboards, mice or pushbuttons, external computing devices, mobile devices, and transmitters/receivers.

The memory can comprise volatile memory such as random access memory (RAM), read only memory (ROM), electrically erasable programmable read only memory (EEPROM), flash memory, magnetic memory, optical memory or any other suitable memory technology. Memory can also comprise a combination of volatile and nonvolatile memory.

The memory is configured to store a number of program modules for execution by the processor. The modules can, for example, include an event detection module, an effect determination module, and an effect control module. Each program module is a collection of data, routines, objects, calls and other instructions that perform one or more particular task. Although certain program modules are disclosed herein, the various instructions and tasks described for each module can, in various embodiments, be performed by a single program module, a different combination of modules, modules other than those disclosed herein, or modules executed by remote devices that are in communication with the controller.

In embodiments described herein, the controller, which can include a wireless transceiver (including a Bluetooth or infrared transceiver), can be integrated into structural material 102 or separate from the structural material. In further embodiments, the controller can be on a separate device from the structural material, but is suitably connected via a wired or more suitably a wireless signal, so as to provide activating signal 150 to the various components of the systems and smart materials described herein.

For example, the controller can provide activating signal 150 to actuator drive circuit, which in turn communicates with power supply 108, of the smart materials described herein, so as to provide haptic feedback to a user of a smart material or system as described herein. For example, desired haptic feedback can occur, for example, when a mobile phone or other device to which a controller is paired via wireless connection receives a message or email. Additional examples include a controller being associated with devices such as game controllers, systems or consoles, computers, tablets, car or truck interfaces or computers, automated payment machines or kiosks, various keypad devices, televisions, various machinery, etc. In such embodiments, the controller suitably provides activating signal 150 to an actuator drive circuit, to provide haptic feedback to a user in response to a signal originated by or from an external device. The device can also be a part of the wearable on which the various components of the haptic feedback systems described herein are contained. Exemplary feedback or signals that can be provided by a device, include, for example, indications of incoming messages or communication from a third party, warning signals, gaming interaction, driver awareness signals, computer prompts, etc.

Sensing signal 450 can also be sent to such devices to indicate a user interaction, and request further feedback or information from an external device, including for example, additional haptic feedback. In embodiments, sensing signal 450 can be sent to a device such as a computer, smart phone, tablet, game console or interface, car interface, etc., for receiving and processing the user interaction. Based upon this user interaction, the device may take additional action, e.g., sending a message, initiating a phone call, moving a character in a game, etc., and/or may provide additional haptic feedback to the user.

In further embodiments, the smart materials and components described herein can be integrated with or be part of a virtual reality or augmented reality system. In such embodiments, the smart materials can provide haptic feedback to a user as he or she interacts with a virtual or augmented reality system, providing responses or feedback initiated by the virtual reality or augmented reality components and devices. User interaction with the smart materials and bifunctional fibers described herein can also be integrated with and be part of a virtual reality or augmented reality system.

The various embodiments described above are provided by way of illustration only and should not be construed to limit the claims attached hereto. Those skilled in the art will readily recognize various modifications and changes that may be made without following the example embodiments and applications illustrated and described herein, and without departing from the true spirit and scope of the following claims.

## Claims

1. A bifunctional fiber, comprising:
a section of the bifunctional fiber for providing haptic feedback, including:
a first conductive element;
a polymeric layer concentrically disposed about the first conductive element; and
a section of the bifunctional fiber for sensing user interaction, including:
a second conductive element concentrically disposed about the polymeric layer;
a first insulating layer concentrically disposed about the second conductive element;
a third conductive element concentrically disposed about the first insulating layer; and
a second insulating layer concentrically disposed about the third conductive element
wherein the bifunctional fiber has a substantially uniform cross-section for substantially an entire length thereof.

2. The bifunctional fiber of claim 1, wherein the first conductive element forms a solid core of the bifunctional fiber, or forms a hollow core of the bifunctional fiber, and wherein the polymeric layer comprises an electroactive polymer selected from the group consisting of poly(vinylidene fluoride), poly(pyrrole), poly(thiophene), poly(aniline) and mixtures, co-polymers, and derivatives thereof, or wherein the polymeric layer comprises a shape memory polymer.

3. The bifunctional fiber of claim 1 or claim 2, wherein the bifunctional fiber is associated with a structural material, preferably wherein the structural material is part of a wearable.

4. The bifunctional fiber of any of claims 1-3, wherein the polymeric layer deforms in response to an electric field between the first conductive element and the second conductive element, to provide the haptic feedback.

5. The bifunctional fiber of any of claims 1-4, wherein the bifunctional fiber provides an electrostatic feedback to the user.

6. The bifunctional fiber of any of claims 1-5, wherein the user interaction results in a compression of the polymeric layer and a change in capacitance or resistance of the bifunctional fiber.

7. A bifunctional fiber, comprising:
a section of the bifunctional fiber for providing haptic feedback or for sensing user interaction, including
a first conductive element;
a polymeric layer concentrically disposed about the first conductive element;
a second conductive element concentrically disposed about the polymeric layer; and
an insulating layer concentrically disposed about the second conductive element,
wherein the bifunctional fiber has a substantially uniform cross-section for substantially an entire length thereof.

8. The bifunctional fiber of claim 7, wherein the first conductive element forms a solid core of the bifunctional fiber, or wherein the first conductive element forms a hollow core of the bifunctional fiber.

9. The bifunctional fiber of claim 7 or claim 8, wherein the polymeric layer comprises an electroactive polymer selected from the group consisting of poly(vinylidene fluoride), poly(pyrrole), poly(thiophene), poly(aniline) and mixtures, co-polymers, and derivatives thereof, or wherein the polymeric layer comprises a shape memory polymer.

10. The bifunctional fiber of any of claims 7-9, wherein the bifunctional fiber is associated with a structural material, preferably wherein the structural material is part of a wearable.

11. The bifunctional fiber of any of claims 7-10, wherein the polymeric layer is configured to deform in response to an electric field between the first conductive element and the second conductive element, to provide the haptic feedback, or wherein the first conductive element and the second conductive element are configured to provide an electrostatic feedback to the user.

12. The bifunctional fiber of any of claims 7-11, wherein the user interaction results in a compression of the polymeric layer and a change in capacitance of the bifunctional fiber.

13. A smart material for providing haptic feedback and for sensing user interaction, comprising:
a structural material and a bifunctional fiber associated with the structural material; or
a structural material, a first bifunctional fiber configured as an actuator associated with the structural material and a second bifunctional fiber configured as a sensor associated with the structural material.

14. The smart material of claim 13, wherein the structural material comprises a textile, preferably wherein the textile is part of a wearable.

15. The smart material of claim 13 or 14, wherein the first bifunctional fiber configured as the actuator and the second bifunctional fiber configured as the sensor are positioned substantially parallel or perpendicular to one another.
